(19) **Europäisches Patentamt / European Patent Office / Office européen des brevets**

(11) **EP 1 255 277 B1**

(12) **EUROPEAN PATENT SPECIFICATION**

(45) Date of publication and mention
of the grant of the patent:
**12.09.2007 Bulletin 2007/37**

(51) Int Cl.:
*H01J 27/20* (2006.01)   *H01J 27/02* (2006.01)
*H01J 37/08* (2006.01)

(21) Application number: **01650051.4**

(22) Date of filing: **01.05.2001**

(54) **Ionizer for gas cluster ion beam formation**

Ionisator zur Bildung eines Gas-Cluster-Ionenstrahls

Ionisateur pour formation d'un faisceu d'agglomerats ionisés

(84) Designated Contracting States:
**DE FR GB**

(73) Proprietor: **TEL Epion Inc.**
**Billerica, MA 01821 (US)**

(72) Inventor: **Dykstra, Jerald P.**
**Austin, TX 78727-1829 (US)**

(74) Representative: **Casey, Lindsay Joseph et al**
**F. R. Kelly & Co.**
**27 Clyde Road**
**Ballsbridge**
**Dublin 4 (IE)**

(43) Date of publication of application:
**06.11.2002 Bulletin 2002/45**

(56) References cited:
**EP-A- 0 428 319**   **WO-A-01/43160**
**DE-A- 19 627 004**   **US-A- 4 126 806**
**US-A- 4 886 969**   **US-A- 5 354 445**
**US-A- 5 521 389**   **US-A- 5 760 405**
**US-A- 5 814 194**

- **PATENT ABSTRACTS OF JAPAN vol. 015, no. 388 (C-0872), 2 October 1991 (1991-10-02) & JP 03 158458 A (MITSUBISHI ELECTRIC CORP), 8 July 1991 (1991-07-08)**
- **PATENT ABSTRACTS OF JAPAN vol. 013, no. 011 (C-558), 11 January 1989 (1989-01-11) & JP 63 216967 A (MITSUBISHI ELECTRIC CORP), 9 September 1988 (1988-09-09)**

## Description

### BACKGROUND OF THE INVENTION

The invention relates to the field of ionizers for gas cluster ion beam formation.

It has been shown that ionized beams of gas clusters can be accelerated and directed toward a target or work-piece surface to produce various desirable effects - cleaning, smoothing, sputter etching, deposition, implantation, etc. A body of literature describes the creation and application of gas cluster ion beams. See, for example, U.S. Pat No. 5,814,194 issued to Deguchi et al.

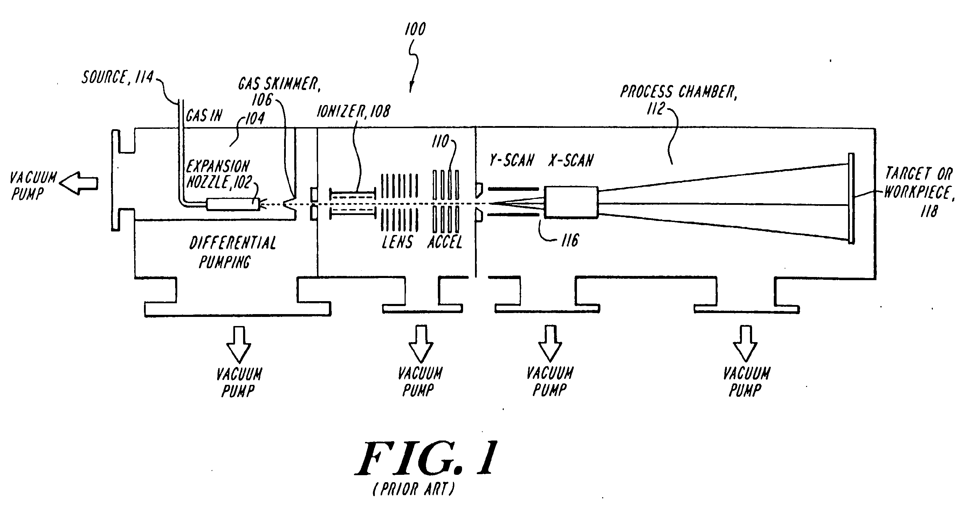

Figure 1 is a functional block diagram of a conventional gas cluster ion beam processing system 100 with a differential vacuum pumping scheme. Gas clusters are formed by creating, with a properly shaped nozzle 102, a cluster jet of gas flowing into a region 104 of substantially reduced pressure. Cooling by adiabatic expansion causes the gas to condense into clusters of from several to several thousand atoms or molecules. A gas skimmer aperture 106 is used to separate the gas molecules that have not been converted into clusters from the cluster jet, minimizing pressure in the downstream regions where such higher pressures would be detrimental (e.g., ionizer 108, accelerator 110, and process chamber 112).

Although not essential, it is sometimes desirable to also employ a differential vacuum pumping scheme, as shown in Figure 1, to further help isolate the downstream regions from the higher pressure source region. Suitable source 114 gases are (for example) argon, other inert gases, oxygen, nitrogen, oxygen bearing gases such as carbon dioxide, nitrogen bearing gases, halogens and halogen bearing gases. Because, during cluster impact, transiently high temperatures and pressures obtain, chemical reactions are facilitated. Therefore, chemically reactive gases like oxygen, nitrogen, halogens or gases bearing those elements as a constituent are also used because of the surface chemical reactions they can effect. Inert gases process the substrate surfaces by mechanical action. Of course, mixtures of inert gases with reactive gases are also possible.

After the cluster jet (which is a substantially neutral beam of clusters) has been formed, the clusters are ionized in the ionizer 108. The ionizer is typically an electron impact ionizer that produces thermal electrons from one or more incandescent filaments. It accelerates and directs the electrons, causing them to collide with the gas clusters in the gas cluster jet. The electron impact ejects electrons from the clusters, causing part of the clusters to become positively ionized.

Once ionized, suitably biased electrodes extract the cluster ions from the ionizer, focus them to form a beam, and accelerate them to a desired energy, typically from 1 keV to several tens of keV or perhaps even a few hundred keV. Not shown, but sometimes utilized, is a mass selector for selecting clusters of a certain mass or within a certain range of masses. Such mass selectors can be, for example, a transverse magnetic field for deflecting monomer ions and other light ions (such as cluster ions having approximately ten or fewer atoms or molecules) out of the beam and passing more massive cluster ions. The accelerated ion clusters may be scanned by scanning mechanisms 116 using well known electrostatic scanning techniques to uniformly process the surface of the target 118 or work-piece. The extracting, focusing, accelerating, mass selecting, and scanning all are made possible by virtue of the fact that the beam of clusters is ionized.

GCIB can be used for many surface processes: smoothing, etching, reacting, depositing, etc. Many of the preferred GCIB processes produce their desired results in proportion to the intensity of the ionized cluster beam that is delivered to the target or work-piece. The beam intensity is dependent on several factors, including: intensity of the neutral gas cluster jet formed by the nozzle (cluster formation efficiency); fraction of the neutral cluster jet that is subsequently ionized (the ionization efficiency); and fraction of the ionized clusters that are subsequently transported to the target or work-piece (the transport efficiency).

Other factors such of the acceleration potential, the cluster size, the constituent gas of the clusters, etc. are also important to the effectiveness and efficiency of the process.

One of the objects of the invention is to improve the efficiency of GCIB processing by increasing the fraction of the neutral clusters in the jet which become ionized (increasing ionization efficiency). Since increased ionization efficiency can increase the GCIB intensity, then it follows that the productivity of various GCIB processes will be improved by increased ionization efficiency.

### SUMMARY OF THE INVENTION

According to an aspect of the present invention, there is provided a neutral beam ionizing apparatus as specified in claim 1.

In accordance with the invention there is provided a neutral beam ionizing apparatus for electron impact ionization of a substantially cylindrical neutral beam, the ionizing apparatus including at least one electron source, and an elliptically cylindrical ionizing region defined by a pair of co-focal elliptically cylindrical electrodes biased so as to cause electrons emitted from the at least one electron source to orbit repeatedly through the axis of the substantially cylindrical beam to be ionized. In one embodiment, the elliptically cylindrical ionizing region includes a pair of co-focal elliptically cylindrical electrodes biased so as to cause electrons emitted from the at least one electron source to orbit repeatedly through the axis of the substantially cylindrical beam to be ionized. The pair of co-focal elliptically cylindrical electrodes comprise a shield reflector electrode and an anode reflector electrode that is substantially transparent to electrons, and the neutral beam axis can lie substantially along a first focus of the pair of co-focal elliptically cylindrical electrodes. The elliptical cylinder and an electron source can lie along a second focus of the elliptical cylinder. The at least one electron source can include a non-inductively formed filament surrounded by a cylindrical anode concentric with the second focus of the elliptical cylinder. In an alternative embodiment, the neutral beam axis lies substantially along a first focus of the elliptical cylinder, and the electron sources are disposed to lie outside of the elliptical cylinder and to direct one or more beams of electrons through a focus of the elliptical cylinder. In other embodiments, the at least one electron source includes at least one electron gun disposed to direct at least one beam of electrons through the second focus of the elliptical cylinder. In all of the embodiments, the beam to be ionized can be a gas cluster beam.

## BRIEF DESCRIPTION OF THE DRAWINGS

Figure 1 is functional block diagram of a conventional gas cluster ion beam processing system with a differential vacuum pumping scheme;

Figure 2 is a functional block diagram of a conventional ionizer arrangement;

Figure 3 is a functional block diagram of a conventional GCIB ionizer arrangement;

Figure 4 is a functional block diagram of another conventional GCIB ionizer arrangement;

Figures 5A and 5B are functional block diagrams of a ring filament 500 and beam 502 arrangement viewed along the beam axis and perpendicular to the beam axis, respectively;

Figures 6A and 6B are schematic diagrams of a ring filament, a beam, and a magnetic field caused by the ring filament, viewed along the beam axis and perpendicular to the beam axis, respectively;

Figure 7 is a schematic diagram of an arrangement of a ring filament, a beam, an ionizer body or shield, and an electron acceleration grid;

Figures 8A and 8B are functional block diagrams of a linear filament geometry ionizer configuration viewed along the beam axis and perpendicular to the beam axis, respectively;

Figure 9 is a schematic diagram illustrating the electron gradient and accumulation of electrons at one end for the case of uniform emission along the length of filaments;

Figures 10A and 10B are functional block diagrams of a bifilar filament and beam arrangement viewed along the beam axis and perpendicular to the beam axis, respectively;

Figures 11A and 11B are schematic block diagrams of the ionizer arrangement viewed along the beam axis and perpendicular to the beam axis, respectively;

Figure 12 is a perspective view of the ionizer arrangement of Figures 11A and 11B;

Figures 13A and 13B are functional block diagrams of two alternative filament arrangements that provide for reversing direction of filament current frequently so as to provide self nullifying magnetic fields;

Figure 14 is a schematic diagram of an arrangement in which a filament axis is at one focus of an elliptical cylinder and a beam axis is at the other focus, and the ellipse surface is constructed to be an electron reflector, so that all electrons from the filament must focus on the beam;

Figure 15 is a perspective view of a functional block diagram of an elliptical filament and beam arrangement;

Figures 16A and 16B are functional block diagrams of the elliptical filament and beam arrangement of Figure 15 viewed along the beam axis and orthogonal to the beam axis, respectively;

Figure 17 is an enlargement of the filament and cylindrical anode screen portion of Figure 16A;

Figure 18 is a functional block diagram of an alternative embodiment of an elliptical geometry ionizer in which one or more electron guns are utilized;

Figures 19A and 19B are functional block diagrams of an exemplary embodiment of a linear electron gun arrangement 1900 viewed along the filament axis and perpendicular to the filament axis, respectively; and

Figure 20 is a perspective view of an exemplary embodiment of an ionizer arrangement.

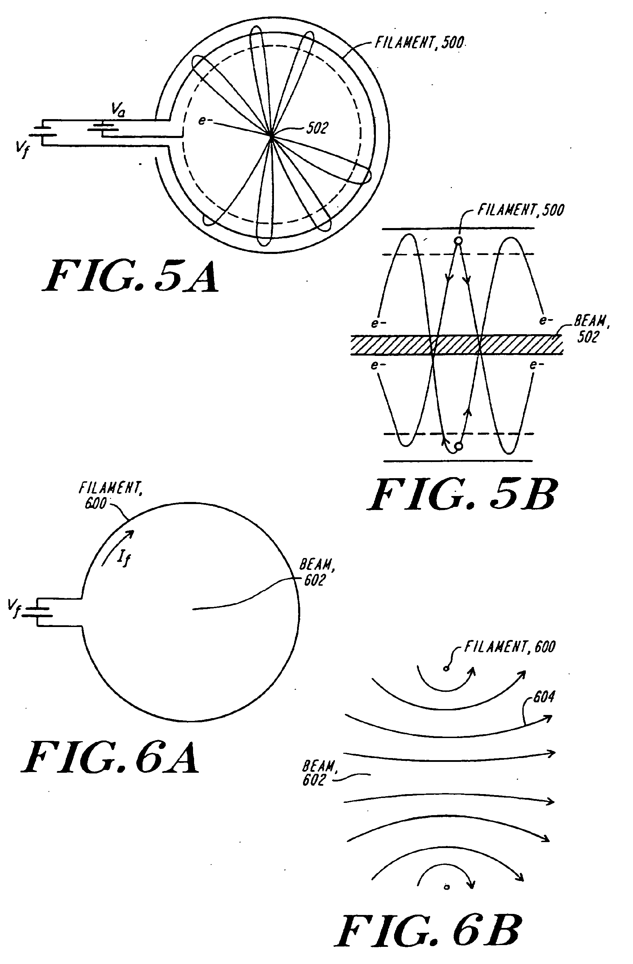

Figures 1-4 relate to prior art. Figures 5-13 are not part of the present invention but are present to assist in the understanding of the invention.

## DETAILED DESCRIPTION OF THE INVENTION

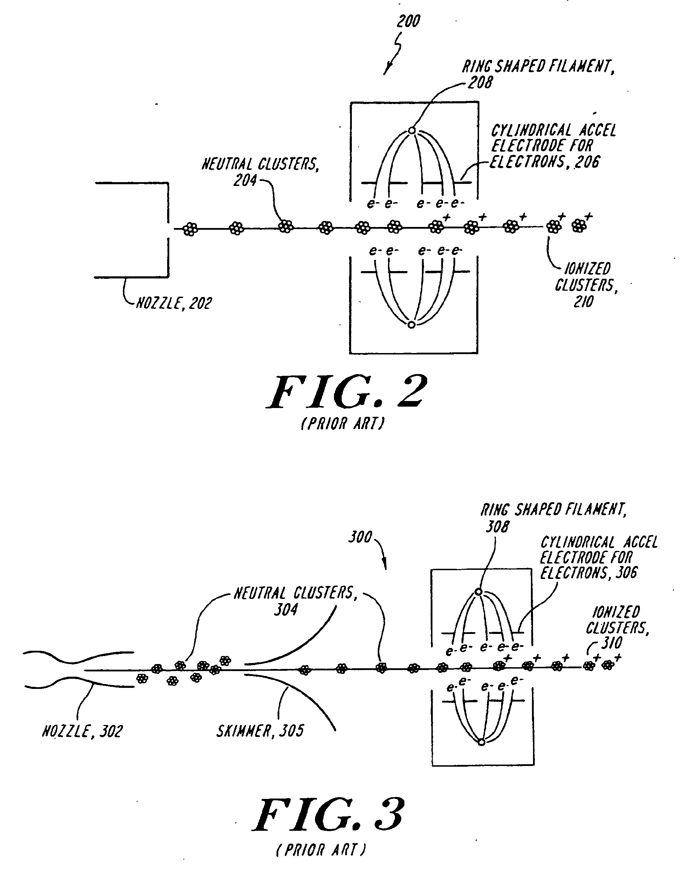

Conventional systems for producing GCIB's commonly have a cylindrically symmetric geometry, being substantially symmetric about the axis of the cluster beam. Often the ionizer has the same cylindrical symmetry or is at least arrayed cylindrically about the central beam axis. An example, referred to as the "ring-filament" geometry, is shown in Figure 2. Figure 2 is a functional block diagram of a conventional ionizer arrangement 200 of a nozzle 202 forming a stream of neutral clusters 204. The clusters are passed through a cylindrical accelerator electrode 206 for electrons with a ring shaped filament 208 to generate the ionized clusters 210.

The ring-filament geometry was originally proposed for use with ion cluster beams before the concept of GCIB existed. The clusters were typically clusters of a vaporized solid condensed by expansion through a nozzle in the vaporizer oven. The same concept as applied to GCIB would be the configuration shown in Figure 3.

Figure 3 is a functional block diagram of a conventional GCIB ionizer arrangement 300 of a nozzle 302 forming a stream of neutral clusters 304 with a skimmer 305. The clusters are passed through a cylindrical accelerator electrode 306 for electrons with a ring shaped filament 308 to generate the ionized clusters 310.

The difference between Figures 2 and 3 is the source of the cluster jet. In Figure 3, gas clusters are formed by creating a supersonic jet of gas through a properly shaped nozzle into a region of substantially reduced pressure. Adiabatic expansion causes the gas to condense into clusters of atoms or molecules. The gas skimmer aperture separates the majority of the gas molecules from the cluster jet forming a neutral cluster beam.

In both cases, a ring-shaped-filament surrounds the cluster beam. The thermionic filament is electrically heated to emit thermal electrons, which are usually accelerated by a biased acceleration grid electrode, into the substantially cylindrical beam of neutral clusters. Some of the energetic electrons strike atoms in some of the neutral clusters, ionizing the atoms by electron impact ionization (ejection of an electron by impact of the incident electron). Such clusters thus acquire a positive charge and are referred to as cluster ions or in the case of gas clusters, gas cluster ions.

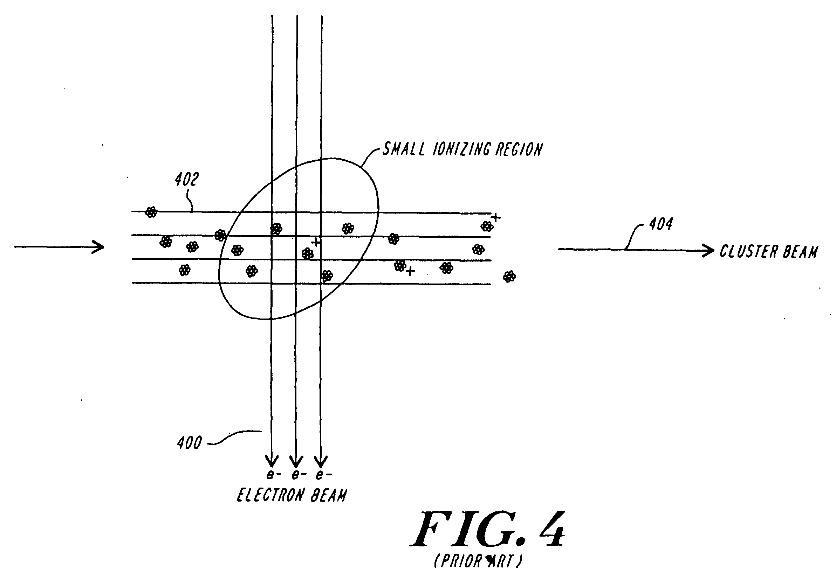

Other conventional approaches to cluster ionization include directing an electron beam 400 (which could be diffuse or pencil shaped or sheet shaped) perpendicularly across a neutral cluster beam 402 (as shown in Figure 4) to form a cluster beam 404, or irradiating the neutral cluster beam with a source of photons to photoionize a portion of the clusters.

In the case of the perpendicular electron beam, the ionization efficiency is relatively low because the ionizing region is generally small (though this is a function of the size and shape of the electron beam) and the electrons in the beam only make a single pass through the beam of neutral clusters and then are lost.

In straightforward photo-ionization techniques a diffuse or collimated beam of photons is directed at the neutral cluster beam, usually only making a single pass through the beam. For the same reasons, the ionization efficiency is likely to be low.

The ring-filament geometry shown in Figure 3 appears in more detail in Figure 5, where possible electron trajectories are shown. Figures 5A and 5B are functional block diagrams of a ring filament 500 and beam 502 arrangement viewed along the beam axis and perpendicular to the beam axis, respectively. Here it is assumed that the current in the electrically heated filament is low so as not to influence the electron trajectories. $V_f$ is the filament heating power supply and $V_a$ is the anode power supply used to bias the grid electrode used to accelerate the electrons. The filament voltage, $V_f$ is chosen to provide sufficient current flow in the filament so that the required number of thermal electrons can be thermally emitted.

A threshold for ionization occurs at the first ionization potential of the species to be ionized. For Ar atoms, the first ionization potential is approximately 15.7 volts. Thus, for ionization to occur $V_a$ must be greater than 15.7 volts (for Ar atoms). In the case of clusters rather than atoms, one can expect that the ionization potential is somewhat different from that for atoms. Highest ionization efficiency for many gases occurs when the impact ionizing electron has 2 to 3 times first ionization potential of the species to be ionized.

The quantities of electrons that can be produced in a space charge limited emission increase with increasing $V_a$. Thus, a rule of thumb that has been historically applied is that $V_a$ should be on the order of 3 or more times the expected first ionization potential for the species to be ionized. This means for most gases, that Va should be on the order of at least a few tens of volts. Typically, $V_f$ is a few volts and $V_a$ is a few tens of volts to a few hundred volts. The strong electric field between the thermionic filament and the anode grid assures that electrons, initially emitted from the thermionic filament with a small thermal energy, enters the cylindrical region within the anode grid traveling in a radial direction, and thus directed at the beam axis at the axis of the cylinder.

The cylindrical electric field in the region between the anode grid and the outer shield forms a cylindrical reflector for electrons which redirects electrons repeatedly toward the beam provided they make no collisions or do not escape the ends of the cylinder. A closed conductive container shields its interior from external electrical fields, so except for internal space charge, which is small in typical ionizers (and assuming the region to be free of magnetic fields), the interior of the anode cylinder is a field free region and the electron travels in a nearly straight line through the beam and back out of the grid, where the strong external fields reflect it back to the interior of the cylinder, again in a radial direction. It is seen that a single electron may orbit, making multiple passes through the beam axis with a resulting increased likelihood of ionizing a cluster.

Several mechanisms act to remove electrons. The higher electron density near the center (in the axial direction) of the cylinder (because the thermionic filament encircles this region) results in a central space charge that repels electrons toward both ends of the cylinder. Also, the existence of a positively charged beam in the downstream direction of the beam (because positive ions are created in the beam by electron impact ionization) tends to attract electrons towards the beam at the downstream end of the ionizer, where the electrons may escape the ionizer.

Electrons are also removed from the ionizer by collision. In order to make multiple passes through the ionizer, the residual gas pressure must be low enough so that the mean-free-path, $L_c$, of the electrons is at least several times larger than the diameter of the cylinder. Typical ionizers have diameters on the order of a few centimeters. At 300 Kelvin, in an Argon atmosphere, as might be the case when Ar gas clusters are being ionized, $L_e$ can be calculated to be approximately 3 cm at 13.33

Pa ($10^{-2}$ Torr), approximately 30 cm at 1.33 Pa ($10^{-3}$ Torr), and approximately 300 cm at 0.133 Pa ($10^{-4}$ Torr). Hence, it is desirable that inside the ionizer, outside of the beam, the pressure be 1.33 Pa ($10^{-3}$ Torr) or less. Of course, inside the beam a higher collision cross section, therefore a shorter $L_e$ is desirable. It is desirable that the transparency of the anode grid to electrons be high (preferably 80% or more transparent) so that few electrons strike the anode.

However, a more important consideration for loss of electrons is that in the case of practical thermionic filaments, it is normal that the filament wire has a sufficiently large diameter to assure long filament life. In such case, a large electrical current flowing in the filament ($I_f$) is required to heat the thermionic filament to a temperature high enough that an adequate quantity of thermions is emitted. For practical reasons, such currents are usually DC. They produce a static magnetic flux (B) that surrounds the filament and said field influences the trajectories of electrons in the ionizer.

Figures 6A and 6B, useful for understanding the invention, are schematic diagrams of a ring filament, a beam, and a magnetic field caused by the ring filament, viewed along the beam axis and perpendicular to the beam axis, respectively. As shown in Figures 6A and 6B, the interaction between a ring filament 600 and beam 602 produces a solenoidal magnetic field 604.

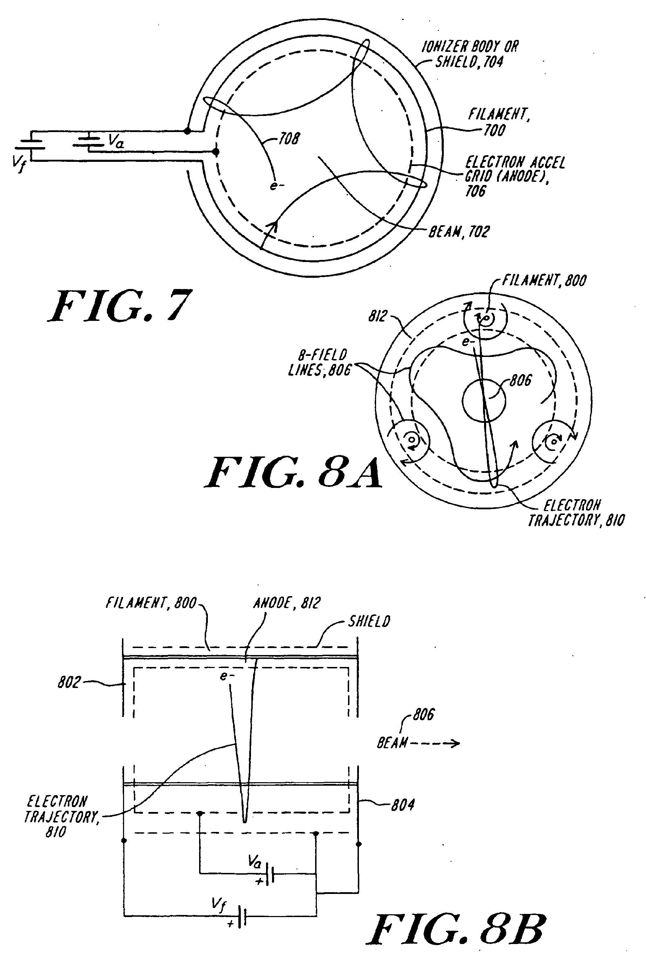

In the plane of the filament ring, the strength of the field is somewhat uniform (being a little stronger near the filament). The approximate effect of this field on the electron trajectories shown in Figure 5 is to cause them to orbit around the magnetic flux lines. An example of a possible trajectory 708 for an electron in a solenoidal magnetic field is shown in Figure 7. Figure 7 is a schematic diagram of an arrangement of a ring filament 700, a beam 702, an ionizer body or shield 704, and an electron acceleration grid 706.

The radius of curvature of the electron orbit due to the magnetic field is smaller for increasing magnetic field. Hence, the exact shape of the trajectory 708 depends on the magnitude of the filament current, $I_f$, and the uniformity of the field. The important point is that because the initial trajectory is radial and because the orbit due to the magnetic field is (approximately) circular, the trajectories no longer pass through the beam and cylinder axis. The central region of the cylinder, where it is desired that beam ionization takes place, is sparse in electrons. If the beam is sufficiently large and the magnetic field not too strong, a portion of the beam may be traversed by the electrons, but the ring-filament geometry is clearly unfavorable for efficient ionization in the case of the large filament currents which are desirable.

Another ionizer configuration not forming part of the invention, is shown in Figures 8A and 8B. Figures 8A and 8B are functional block diagrams of a linear filament geometry ionizer configuration viewed along the beam axis and perpendicular to the beam axis, respectively. There are multiple (typically 3) parallel linear filaments 800 stretched between two endplates 802, 804 that serve as mechanical supports and electrical connections for the filaments. The filaments are parallel to the beam 806 and arrayed in a cylindrical pattern around the beam. Electrical current (dc) flows in the same direction in all the filaments, so they have a static magnetic field surrounding them with flux lines 808 (B).

In the typical case of three filaments, the magnetic field shape inside the cylinder is tri-cuspid, strongest nearest a filament and decreasing in intensity with increasing radial distance from the filament. The field influences the trajectories 810 of electrons inside the cylindrical anode screen. Neglecting space charge, the interior of a cylindrical anode screen is an electrical field free region so the magnetic field dominates the electron motion inside the anode cylinder. The electrons are deflected in the direction of the filament (conventional) current flow and drift toward one end of the ionizer.

If the conventional filament current flows in the direction the beam is traveling, the electron drift due to the resulting magnetic field will be opposite that direction. Along the beam axis, there will be no electrons at the exit of the ionizer and a concentration of electrons at the entrance, where they will recombine or escape the ionizer. The drift rate and hence the number of times the electrons cross the beam axis are dependent on the magnitudes of the filament currents and the resultant magnetic field strength. Higher filament currents will give a stronger gradient between entry and exit. The concentration at the entrance means that there is likely to be high recombination there and greater escape of electrons through the entrance aperture of the ionizer.

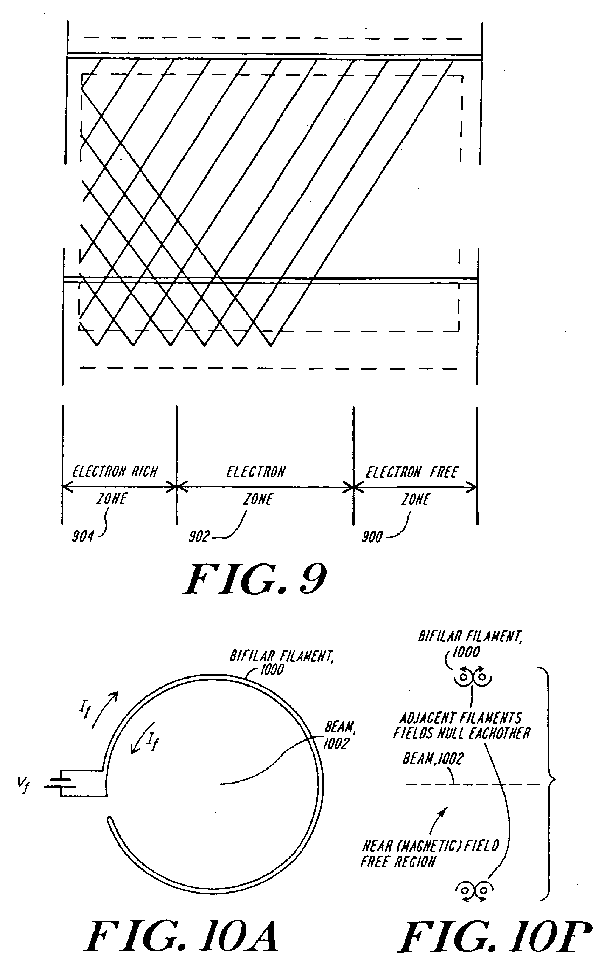

Figure 9 is a schematic diagram illustrating the electron gradient and accumulation of electrons at one end for the case of uniform emission along the length of the filaments. There is an electron free zone 900, a zone 902 where electrons make only one pass through the beam, and an electron rich zone 904 where electrons make second and subsequent passes through the beam. Although this geometry is superior to the ring-filament geometry because it permits the electrons to cross the beam axis, sometimes more than once, it is not optimal because of the increasing axial electron gradient it produces with increasing filament current. The gradient results in increased electron loss at the high concentration end. This loss is enhanced if the electron concentration is at the cluster beam downstream end where positive beam space charge can help extract electrons from the electron rich zone. For this reason, it is best if the beam direction and the conventional current direction in the filaments are the same so that the magnetic field tends to cause the electrons to drift toward the entrance end of the ionizer.

To maximize the efficiency of the cylindrical ring-filament geometry, the central region of the ionizer should be as much as possible a field free region (to permit trajectories similar to those shown in Figure 5), and the ends of the cylinder should be sealed as effectively as possible in order to reduce electron leakage at the ends.

Replacing the ring filament with a non-inductively wound (or bifilar) filament can practically eliminate the magnetic field produced by the filament current. This improvement is shown in Figures 10A and 10B.

Figures 10A and 10B are functional block diagrams of a bifilar filament 1000 and beam 1002 arrangement not forming part of the invention, viewed along the beam axis and perpendicular to the beam axis, respectively. If $V_a$ is much greater than the thermal energy of the electrons emitted by the filament, their motion at the anode screen will be generally radial in direction. With a single bifilar ring and no magnetic field, the electrons will tend to be concentrated in the plane of the filament with space charge causing them to drift away from that plane.

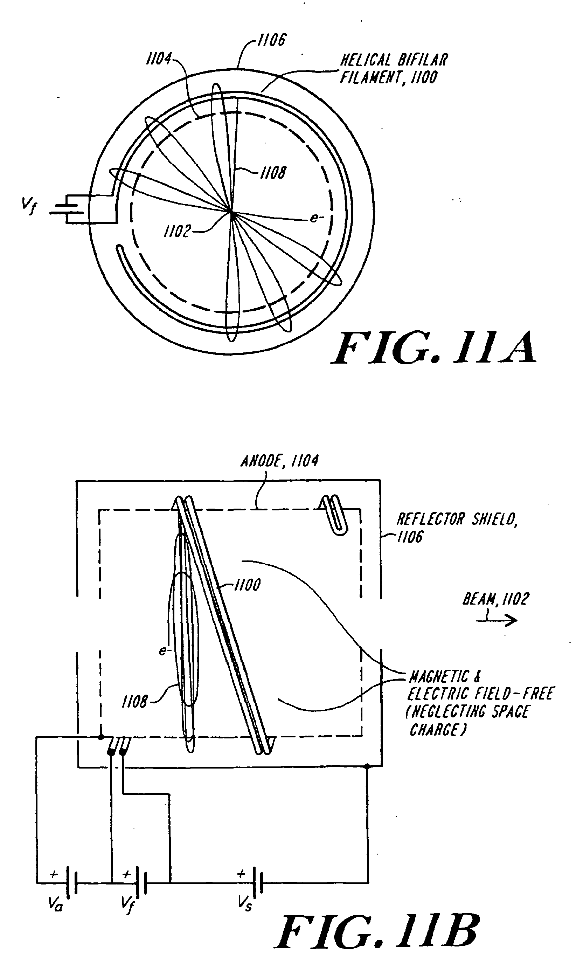

Making several bifilar filament loops or winding a helical (bifilar) filament 1100 around a cylindrical anode 1104 within a reflector shield 1106, has the advantage of distributing the electrons along the length of the cylinder and beam 1102 axis. Figures 11 A and 11B are schematic block diagrams of an ionizer arrangement not part of the invention viewed along the beam axis and perpendicular to the beam axis, respectively, and is an example of such a configuration showing the orbital form 1108 for a single electron. Since the interior of the cylindrical anode screen is essentially field free, the electrons tend to orbit repeatedly through the beam without drift until they strike a gas cluster or some other object. By keeping the pressure low and using an anode screen transparent to electrons, the likelihood of collision with a cluster is increased.

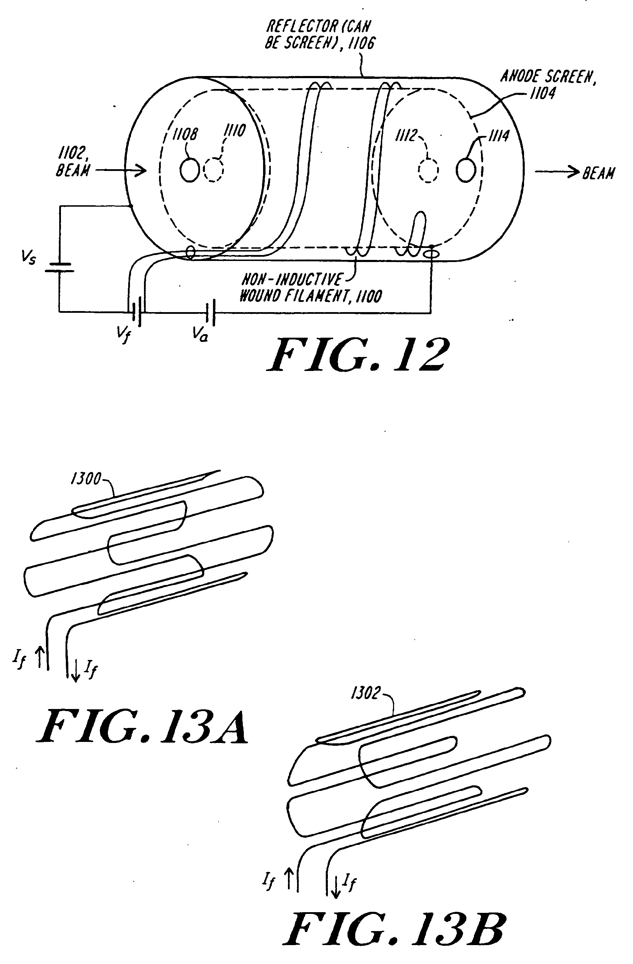

Figure 12 is a perspective view of the ionizer arrangement of Figures 11A and 11B. It will be appreciated that the anode screen 1104 and reflector 1106 (which may also be a screen) are both closed on the ends except for the beam apertures 1108, 1110, 1112 and 1114. Also, the reflector 1106 is preferably biased ($V_s$) slightly (several volts) more negative than the most negative end of the filament to assure that no electron can strike the reflector and recombine. $V_s$ can be made zero with the result that only electrons emitted near the negative end of the filament can strike the shield, but setting $V_s$ to a few volts is better. Fewer electrons will recombine with the reflector, and the potential will help to prevent electrons from leaking out of the downstream end of the cylinder due to the beam's positive space charge near the downstream exit. The reflector can be a perforated enclosure or partially transparent screen to permit effective vacuum pumping of the ionizer region so the electron mean-free-path, $L_e$, can be long.

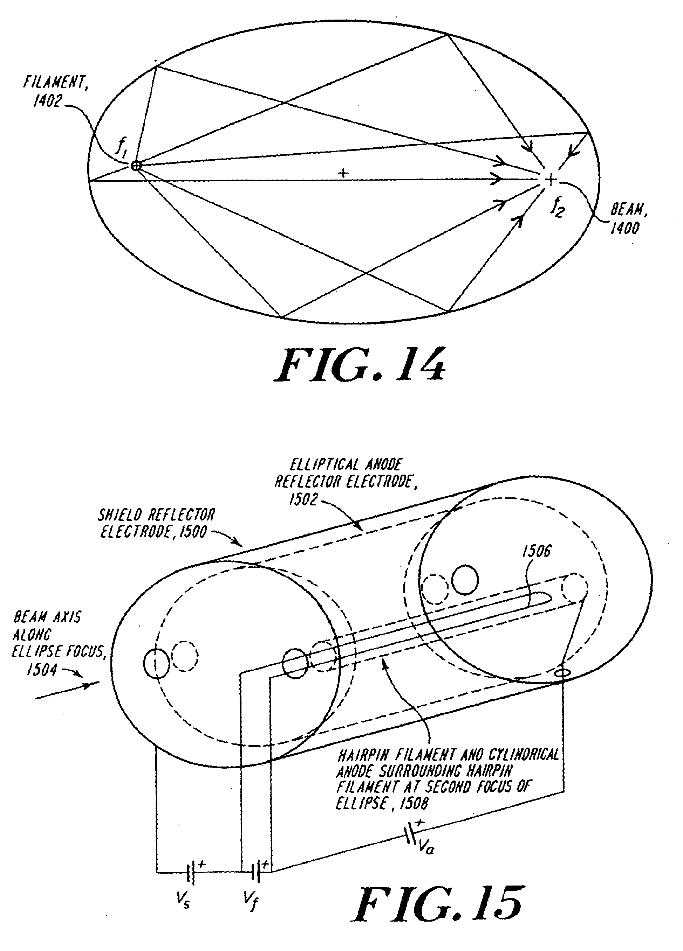

Two alternative filament arrangements that may be mechanically simpler to support than the bifilar helical filament geometry shown in Figure 12, but which can still provide reduced magnetic fields in the interior of a cylindrical region are shown in Figures 13A and 13B. The arrangements provide for reversing direction of the filament current frequently so as to provide self nullifying magnetic fields. For the same number of reversals and same total filament length, the configuration 1302 is somewhat more effective at reducing the interior magnetic fields than the configuration 1300 because the parallel filament segments having opposite current flows are closer together.

Although the configurations of Figures 11A-11B and 13A-13B focus electron trajectories through the beam axis, by using an elliptical geometry a superior configuration can be achieved. The use of the optical properties of elliptical reflectors has been used to focus electrons.

An ellipse has two foci. If the interior surface of an ellipse is a reflector, electrons emitted at one focus will be focused on the other focus. If a filament axis is at one focus of an elliptical cylinder and a beam axis is at the other focus and the ellipse surface is constructed to be an electron reflector, then all electrons from the filament must focus on the beam. This concept is illustrated in the diagram of Figure 14. For an ellipse with its center (intersection of major and minor axes) at the origin, the equation of the ellipse is given by the equation:

$$(x^2/a^2)+(y^2/b^2)=1$$

where a is the length of the semi-major axis and b is the length of the semi-minor axis.

The foci are located on the major axis at a distances $\pm c$ from the center, where:

$$c^2 = a^2 - b^2$$

These two relationships permit locating the two foci of any ellipse if the lengths of the semi-axes are known or can be measured.

The ellipse in Figure 14 has been drawn more eccentric than is necessary to achieve the usefulness of this concept in order to make the concept clear. In a practical situation, the two foci ($f_1$ and $f_2$) only need be separated by a large enough space to separate a beam 1400 and a filament 1402 and associated structures. The heated bare filament 1402 as shown Figure 14 only emits low energy thermal electrons, and the quantity of such electrons is limited by space charge effects. It is desirable to provide an acceleration grid structure to increase the energy of the electrons and to extract larger electron currents.

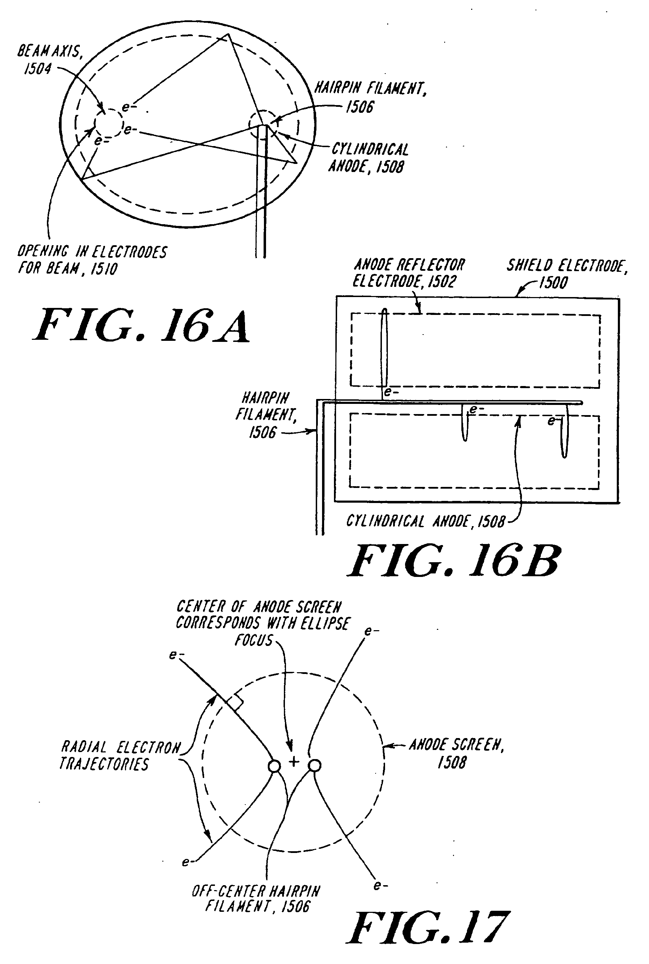

A functional block diagram of an elliptical filament and beam arrangement is shown in perspective in Figure 15, and in two orthogonal views (along the beam axis and orthogonal to the beam axis, respectively) in Figures 16A and 16B. It will be appreciated that a reflector is defined by two electrodes, an outer electrode or shield 1500, which may be solid or a perforated surface or screen, and an inner electrode 1502, which is a high transparency (having electron transparency of 80% or greater) wire screen or similarly transparent electrode. The two reflector electrodes are both elliptical in section, having their foci at the same two locations (co-focal ellipses, specifically: $a_1{}^2-b_1{}^2= a_2{}^2-b_2{}^2$, where $a_1$ and $b_1$ are semi-major and semi-minor axes respectively of the first ellipse and where $a_2$ and $b_2$ are semi-major and semi-minor axes for the second ellipse). The focal locations are arranged to coincide with the nominal centerlines of a beam path 1504 and a hairpin filament 1506. A cylindrical anode 1508 surrounding the hairpin filament is also high transparency screen and is connected to, or otherwise biased similarly to, the elliptical anode reflector element 1502.

$V_f$ is the filament heating power supply and $V_a$ is the anode power supply used to bias the circular cylindrical anode 1508 surrounding the hairpin filament 1506 to extract and accelerate the electrons from the electron cloud near the filament. The bifilar hairpin filament provides thermal electrons without providing a magnetic field strong enough to influence the electron trajectories within the ionizer appreciably. Typically $V_f$ is a few volts and $V_a$ is a few hundred volts.

The elliptical anode reflector screen electrode and the shield reflector electrode are both closed on the ends except for a beam aperture 1510 and filament opening. Also, the reflector is biased ($V_s$) slightly (a few volts) more negative than the most negative end of the filament to assure that no electron can strike the reflector and recombine. $V_s$ can be made zero with the result that only electrons emitted near the negative end of the filament can strike the shield, but setting $V_s$ to a few volts is better. Fewer electrons will recombine with the reflector, and the electrical potential will help to prevent electrons from leaking out of the downstream end of the cylinder near the beam aperture due to the beam's positive space charge near the downstream exit. It is acceptable that the shield reflector be a perforated enclosure or partially transparent screen to permit effective vacuum pumping of the ionizer region so the electron mean-free-path, $L_e$, can be long. If the shield reflector is a screen, then it is desirable to increase the magnitude of $V_s$ sufficiently that the reflection point occurs sufficiently distant from the shield reflector so that the reflecting equipotential surface (V = filament potential) is smooth enough to be an accurate elliptical reflector (not influenced by the size of the screen mesh).

The strong electric field between the filament and the anode screen assures that electrons, initially emitted from the filament with a small thermal energy, exit the cylindrical anode screen and enter the elliptically cylindrical region within the anode grid traveling in a direction straight away from the focus of the ellipse, and thus appearing to have originated at the focus (having a virtual origin at the focus). This condition is accomplished when $V_a$ is large compared to the energy of thermions which assures that any non-radial component of velocity of the electrons when they exit the cylindrical anode screen is negligible compared to their radial velocity.

Figure 17 is an enlargement of the filament and cylindrical anode screen portion of Figure 16A. Figure 17 illustrates that the electrons appear to have originated at the focus of the ellipse. Since the majority of thermal electrons emitted by a filament of less than 3000 K have an energy of less than 0.5eV, an anode voltage, $V_a$, of several tens of volts will suffice to establish the virtual source condition.

Inside the electric field free region (neglecting space charge) between the cylindrical anode screen and the elliptically cylindrical anode reflector electrode, the electrons travel in a straight line (as seen in Figure 16). However, the strong electric field in the region between the elliptical anode grid and the elliptical outer shield forms an elliptical reflector for electrons which redirects electrons repeatedly toward two foci of the ellipse provided they make no collisions or do not escape the ends of the elliptical cylinder. A closed conductive container shields its interior from external electrical fields, so except for internal space charge, which is small in typical ionizers (and assuming the region to be free of magnetic fields), the interior of the elliptical anode cylinder is a field free region and the electron travels in a nearly straight line inside of the elliptical cylinder.

A single electron may orbit, making multiple passes through the beam axis with a resulting increased likelihood of ionizing a cluster. An electron that passes through the beam without collision may be reflected back through the circular cylinder anode grid toward the filament. There, it may be either reflected back, pass through the anode cylinder making another pass through the ionizer, or strike the filament. If it strikes the filament, it may stimulate the secondary emission of one or more additional electrons, perpetuating the process.

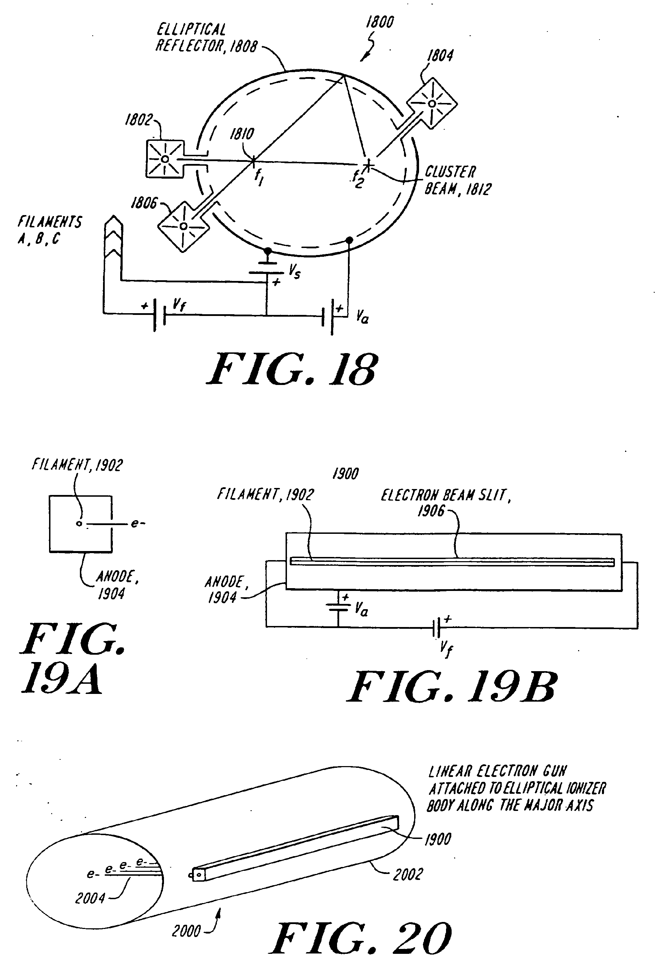

Figure 18 is a functional block diagram of an alternative embodiment of an elliptical geometry ionizer 1800 in which a hairpin filament and circularly cylindrical anode screen are replaced with one or more electron guns 1802, 1804, 1806. The ionizer 1800 includes an elliptical reflector 1808 having a filament 1810 and a cluster beam path 1812 arranged at its foci. To be effective, electron guns should direct the electron beams through a focus of the ellipse and perpendicular to the cluster beam path. There can be multiple electron guns, but each should be pointed to direct the electrons through a focus of the ellipse.

The use of such electron guns can avoid the difficulty of obscuring part of the interior of the elliptically cylindrical ionizer by having a filament and anode cylinder there. As a result of the reduced likelihood of collision, the electron path length within the ionizer can be longer with corresponding increased ionization efficiency (greater probability that a single electron will ionize a cluster).

The electron beams must be disposed so as to pass first through one of the two foci of the ellipse. Thus, the electron beams will have a virtual origin at the focus. There are only two locations on the ellipse where the entering electron beam can be perpendicular to the tangent to the ellipse, namely, at the two ends of the major diameter of the ellipse. For simple mechanical construction, it may be convenient to locate a gun or guns at either end of a major diameter (as shown in Figure 18, gun 1802). A linear array of guns can be placed along the line that corresponds to the locus of the ends of all major diameters of the ellipse. An alternative is to use a linear electron gun running along the outside length of the elliptical cylinder. Such an arrangement is shown in Figures 19A and 19B.

Figures 19A and 19B is a functional block diagram of an exemplary embodiment of a linear electron gun arrangement 1900 viewed along the filament axis and perpendicular to the filament axis, respectively. The gun includes a filament 1902, a surrounding anode 1904 and an electron beam slit along the length of the anode.

Figure 20 is a perspective view of an exemplary embodiment of an ionizer arrangement 2000. The ionizer includes an elliptical body 2002 with the gun arrangement 1900 attached along the major axis. The gun injects a sheet beam 2004 of electrons along the length of the ionizer.

An electron gun need not necessarily be located on a major diameter to be effective if it is directed so that its beam passes through a focus of the ellipse. Guns 1804 and 1806 of Figure 18 are examples of an alternative arrangement.

In many GICB processing applications, it is desirable to avoid contamination of the work-piece with undesired atomic species during processing. Heated filaments such as the hairpin filament 1506 used in the elliptical geometry ionizer of Figures 15 and 16A-16B are generally of a metal such as tungsten, tantalum, or the like, and may evolve atoms or ions of the metal by evaporation when heated or by sputtering. An electron gun often includes a hot filament or entails a process that causes sputtering within the gun. Thus, an electron gun may also produce a beam of undesired contaminants, metal or otherwise.

Such contaminant atoms or ions may interact with the cluster beam so as to become entrained in or combined with the beam, contaminating it with the metal or other contaminant. A contaminated cluster beam may produce undesirable results at the work-piece. Hence, direct exposure of a beam to a filament or the output of an electron gun may not be desirable in some applications of GCIB. In Figure 18, it can be seen that electron guns located at positions such as with guns 1802(major diameter) and 1804 both are arranged so that the cluster beam is exposed to the direct output of the electron gun, including any contaminants it may be ejecting. However, electron gun 1806, by virtue of the reflecting property of the ionizer transmits electrons to the beam, but does not transmit any neutral or positively charged contaminants to the beam. The contaminants will be deposited on the elliptical reflector, or if the reflector is a screen, may pass through and subsequently be removed by the vacuum system. Thus, an ionizer having elliptical geometry and using an electron gun or guns not directed at the beam except through reflection and produce a lower level of GCIB contamination and improved processing results for contamination sensitive applications.

Although the present invention has been shown and described with respect to several preferred embodiments thereof, various changes, omissions and additions to the form and detail thereof, may be made therein, without departing from the scope of the invention.

## Claims

1. A neutral beam ionizing apparatus for electron impact ionization of a substantially cylindrical neutral beam, having a beam axis (1504), said ionizing apparatus comprising at least one electron source; **characterised in that** the apparatus further comprises an elliptically cylindrical ionizing region defined by a pair of co-focal elliptically cylindrical electrodes biased so as to cause electrons emitted from said at least one electron source to orbit repeatedly through the beam axis (1504) of the substantially cylindrical neutral beam, said pair of co-focal elliptically cylindrical electrodes comprising an anode reflector electrode (1502) and a shield reflector electrode (1500), the anode reflector electrode (1502) being substantially transparent to electrons; and wherein the beam axis (1504) lies substantially along a first focus (f1) of the pair of co-focal elliptically cylindrical electrodes.

2. An apparatus as claimed in claim 1, wherein the at least one electron source comprises a non-inductively formed filament (1506) surrounded by a circularly cylindrical anode (1508) that is substantially transparent to electrons and is concentric with a second focus of the pair of co-focal elliptically cylindrical electrodes.

3. An apparatus as claimed in claim 1, wherein the neutral beam axis (1504) lies substantially along the first focus of said pair of co-focal elliptically cylindrical electrodes, and wherein the at least one electron source (1802, 1804, 1806, 1900) is disposed to lie outside of the elliptically cylindrical ionizing region and to direct at least one beam of electrons through a focus f2 of said pair of co-focal elliptically cylindrical electrodes.

4. An apparatus as claimed in claim 3, wherein said at least one electron source comprises at least one electron gun (1802, 1804, 1806, 1900).

5. An apparatus as claimed in claim 3, wherein said at least one electron source comprises at least one linear electron gun.

6. An apparatus as claimed in claim 3, wherein said at least one electron source comprises at least one electron gun (1802, 1804, 1806, 1900) disposed to direct at least one beam of electrons through the second focus (f2) of said pair of co-focal elliptically cylindrical electrodes.

7. An apparatus as claimed in any of claims 1-6, wherein the apparatus is adapted for handling a gas cluster beam as the neutral cluster beam.

8. An apparatus as claimed in claim 2, wherein said at least one electron source comprises a source, comprising an non-inductively formed filament (1506) and a circularly cylindrical anode (1508) configured such that said electrons travel in orbits that originate inside of the circularly cylindrical anode (1508) near the second focus, but which appear to substantially originate at said second focus if observed outside of the circularly cylindrical anode (1508).

9. An apparatus as claimed in claim 4, wherein the at least one electron gun is a linear electron gun (1900).

10. An apparatus as claimed in claim 1, wherein said pair of co-focal elliptically cylindrical electrodes is closed at each end except for a beam aperture (1510) and a filament opening.

11. An apparatus as claimed in claim wherein said pair of co-focal elliptically cylindrical electrodes includes an outer electrode (1500) which may be solid or have a perforated surface; and an inner electrode (1502) which has a high electron transparency of 80% or higher.

12. An apparatus as claimed in claim 6 wherein said at least one electron gun is disposed to direct said at least one beam of electrons through the second focus (f2) of said pair of co-focal elliptically cylindrical electrodes and against one or both of said pair of co-focal elliptically cylindrical electrodes (1808) prior to passing through said neutral beam.

## Patentansprüche

1. Neutralstrahlionisierungsvorrichtung zur Elektronenstoßionisierung eines im Wesentlichen zylindrischen neutralen Strahls mit einer Strahlenachse (1504), wobei die genannte Ionisierungsvornchtung wenigstens eine Elektronenquelle umfasst;
**dadurch gekennzeichnet, dass** die Vorrichtung ferner eine elliptisch zylindrische Ionisierungsregion umfasst, die von einem Paar kofokalen, elliptisch zylindrischen Elektroden definiert wird, die so vorgespannt sind, dass sie bewirken, dass von der genannten wenigstens einen Elektronenquelle emittierte Elektronen wiederholt durch die Strahlenachse (1504) des im Wesentlichen zylindrischen neutralen Strahls umlaufen, wobei das genannte Paar kofokale, elliptisch zylindrische Elektroden eine Anodenreflektorelektrode (1502) und eine Schirmreflektorelektrode (1500) umfassen, wobei die Anodenreflektorelektrode (1502) für Elektronen im Wesentlichen transparent ist und wobei die Strahlenachse (1504) im Wesentlichen entlang einem ersten Fokus (f1) des Paares von kofokalen, elliptisch zylindrischen Elektroden liegt.

2. Vorrichtung nach Anspruch 1, wobei die wenigstens eine Elektronenquelle einen nichtinduktiv geformten Faden (1506) umfasst, der von einer kreisförmig zylindrischen Anode (1508) umgeben ist, die für Elektronen im Wesentlichen transparent und mit einem zweiten Fokus des Paares von kofokalen, elliptisch zylindrischen Elektroden konzentrisch ist.

3. Vorrichtung nach Anspruch 1, wobei die Neutralstrahlenachse (1504) im Wesentlichen entlang dem ersten Fokus des genannten Paares von kofokalen, elliptisch zylindrischen Elektroden liegt und wobei die wenigstens eine Elektronenquelle (1802, 1804, 1806, 1900) so angeordnet ist, dass sie außerhalb der elliptisch zylindrischen Ionisierungsregion liegt und dass wenigstens ein Strahl von Elektronen durch einen Fokus f2 des genannten Paares von kofokalen, elliptisch zylindrischen Elektroden gerichtet wird.

4. Vorrichtung nach Anspruch 3, wobei die genannte wenigstens eine Elektronenquelle wenigstens eine Elektronenkanone (1802, 1804, 1806, 1900) umfasst.

5. Vorrichtung nach Anspruch 3, wobei die genannte wenigstens eine Elektronenquelle wenigstens eine lineare Elektronenkanone umfasst.

6. Vorrichtung nach Anspruch 3, wobei die genannte wenigstens eine Elektronenquelle wenigstens eine Elektronenkanone (1802, 1804, 1806, 1900) umfasst, die so angeordnet ist, dass sie wenigstens einen Strahl von Elektronen durch den zweiten Fokus (f2) des genannten Paares von kofokalen, elliptisch zylindrischen Elektroden richtet.

7. Vorrichtung nach einem der Ansprüche 1 bis 6, wobei die Vorrichtung die Aufgabe hat, einen Gasclusterstrahl als Neutralclusterstrahl zu handhaben.

8. Vorrichtung nach Anspruch 2, wobei die genannte wenigstens eine Elektronenquelle eine Quelle umfasst, die einen nichtinduktiv geformten Faden (1506) und eine kreisförmig zylindrische Anode (1508) umfasst, die so konfiguriert ist, dass die genannten Elektronen in Bahnen wandern, die ihren Ursprung innerhalb der kreisförmig zylindrischen Anode (1508) in der Nähe des zweiten Fokus haben, die ihren Ursprung aber im Wesentlichen an dem genannten zweiten Fokus zu haben scheinen, wenn sie von außerhalb der kreisförmig zylindrischen Anode (1508) beobachtet werden.

9.  Vorrichtung nach Anspruch 2, wobei die genannte wenigstens eine Elektronenkanone eine lineare Elektronenkanone (1900) ist.

10. Vorrichtung nach Anspruch 1, wobei das genannte Paar kofokale, elliptisch zylindrische Elektroden an jedem Ende geschlossen ist, mit Ausnahme einer Strahlenapertur (1510) und einer Fadenöffnung.

11. Vorrichtung nach Anspruch 1, wobei das genannte Paar kofokale, elliptisch zylindrische Elektroden eine äußere Elektrode (1500), die massiv sein oder eine perforierte Oberfläche haben kann, und eine innere Elektrode (1502) aufweist, die eine hohe Elektronentransparenz von 80% oder höher hat.

12. Vorrichtung nach Anspruch 6, wobei die genannte wenigstens eine Elektronenkanone so angeordnet ist, dass sie den genannten wenigstens einen Strahl von Elektronen durch den zweiten Fokus (f2) des genannten Paares von kofokalen, elliptisch zylindrischen Elektroden und gegen eine oder beide aus dem genannten Paar von kofokalen, elliptisch zylindrischen Elektroden (1808) richtet, bevor sie durch den genannten neutralen Strahl passieren.

## Revendications

1.  Appareil d'ionisation à faisceau neutre pour l'ionisation par impact d'électrons d'un faisceau neutre essentiellement cylindrique, ayant un axe de faisceau (1504), ledit appareil d'ionisation comprenant au moins une source d'électrons ;
    **caractérisé en ce que** l'appareil comprend en outre une région ionisante elliptiquement cylindrique définie par une paire d'électrodes elliptiquement cylindriques cofocales polarisées de façon à amener les électrons émis depuis ladite au moins une source d'électrons à orbiter de façon répétée à travers l'axe de faisceau (1504) du faisceau neutre essentiellement cylindrique, ladite paire d'électrodes elliptiquement cylindriques cofocales comprenant une électrode réflectrice d'anode (1502) et une électrode réflectrice de blindage (1500), l'électrode réflectrice d'anode (1502) étant essentiellement transparente aux électrons ; et dans lequel l'axe de faisceau (1504) repose essentiellement le long d'un premier foyer (f1) de la paire d'électrodes elliptiquement cylindriques cofocales.

2.  Appareil selon la revendication 1, dans lequel l'au moins une source d'électrons comprend un filament formé non inductivement (1506) entouré d'une anode circulairement cylindrique (1508) qui est essentiellement transparente aux électrons et est concentrique avec un second foyer de la paire d'électrodes elliptiquement cylindriques cofocales.

3.  Appareil selon la revendication 1, dans lequel l'axe de faisceau neutre (1504) repose essentiellement le long du premier foyer de ladite paire d'électrodes elliptiquement cylindriques cofocales, et dans lequel l'au moins une source d'électrons (1802, 1804, 1806, 1900) est disposée pour reposer à l'extérieur de la région ionisante elliptiquement cylindrique et diriger au moins un faisceau d'électrons à travers un foyer f2 de ladite paire d'électrodes elliptiquement cylindriques cofocales.

4.  Appareil selon la revendication 3, dans lequel ladite au moins une source d'électrons comprend au moins un canon d'électrons (1802, 1804, 1806, 1900).

5.  Appareil selon la revendication 3, dans lequel ladite au moins une source d'électrons comprend au moins un canon d'électrons linéaire.

6.  Appareil selon la revendication 3, dans lequel ladite au moins une source d'électrons comprend au moins un canon d'électrons (1802, 1804, 1806, 1900) disposé pour diriger au moins un faisceau d'électrons à travers le second foyer (f2) de ladite paire d'électrodes elliptiquement cylindriques cofocales.

7.  Appareil selon l'une quelconque des revendications 1 à 6, dans lequel l'appareil est adapté pour prendre en charge un faisceau de grappes de gaz comme faisceau de grappes neutre.

8.  Appareil selon la revendication 2, dans lequel ladite au moins une source d'électrons comprend une source, comprenant un filament formé non inductivement (1506) et une anode circulairement cylindrique (1508) configurée de telle sorte que lesdits électrons se déplacent dans des orbites qui proviennent de l'intérieur de l'anode circulairement cylindrique (1508) près du second foyer, mais qui semblent essentiellement provenir dudit second foyer si on les regarde en dehors de l'anode circulairement cylindrique (1508).

9.  Appareil selon la revendication 4, dans lequel l'au moins un canon d'électrons est un canon d'électrons linéaire (1900).

**10.** Appareil selon la revendication 1, dans lequel ladite paire d'électrodes elliptiquement cylindriques cofocales est fermée à chaque extrémité à l'exception d'une ouverture de faisceau (1510) et d'une ouverture de filament.

**11.** Appareil selon la revendication 1, dans lequel ladite paire d'électrodes elliptiquement cylindriques cofocales comporte une électrode externe (1500) qui peut être pleine ou avoir une surface perforée ; et une électrode interne (1502) qui a une transparence aux électrons élevée de 80% ou plus.

**12.** Appareil selon la revendication 6, dans lequel ledit au moins un canon d'électrons est disposé pour diriger ledit au moins un faisceau d'électrons à travers le second foyer (f2) de ladite paire d'électrodes elliptiquement cylindriques cofocales et contre une ou les deux de ladite paire d'électrodes elliptiquement cylindriques cofocales (1808) avant de passer à travers ledit faisceau neutre.

FIG. 1
(PRIOR ART)

*200*

RING SHAPED FILAMENT, *208*

CYLINDRICAL ACCEL ELECTRODE FOR ELECTRONS, *206*

NEUTRAL CLUSTERS, *204*

e- e-    e- e- e-

e- e-    e- e- e-

IONIZED CLUSTERS, *210*

NOZZLE, *202*

# FIG. 2
(PRIOR ART)

*300*

RING SHAPED FILAMENT, *308*

CYLINDRICAL ACCEL ELECTRODE FOR ELECTRONS, *306*

NEUTRAL CLUSTERS, *304*

IONIZED CLUSTERS, *310*

e- e-  e- e- e-

e- e-  e- e- e-

NOZZLE, *302*

SKIMMER, *305*

# FIG. 3
(PRIOR ART)

SMALL IONIZING REGION

402

404

CLUSTER BEAM

+
+
+
+

e- e- e-
ELECTRON BEAM

400

**FIG. 4**
(PRIOR ART)

EP 1 255 277 B1

FILAMENT, 500

$V_a$

$V_f$

e-

502

**FIG. 5A**

FILAMENT, 500

e-

e-

BEAM, 502

e-

e-

**FIG. 5B**

FILAMENT, 600

$I_f$

BEAM, 602

$V_f$

**FIG. 6A**

FILAMENT, 600

604

BEAM, 602

**FIG. 6B**

15

*FIG. 7*

*FIG. 8A*

*FIG. 8B*

ELECTRON RICH ZONE 904

ELECTRON ZONE 902

ELECTRON FREE ZONE 900

## FIG. 9

BIFILAR FILAMENT, 1000

$I_f$

$I_f$

$V_f$

BEAM, 1002

## FIG. 10A

BIFILAR FILAMENT, 1000

ADJACENT FILAMENTS FIELDS NULL EACHOTHER

BEAM, 1002

NEAR (MAGNETIC) FIELD FREE REGION

## FIG. 10P

*1106*
*1104*
HELICAL BIFILAR
FILAMENT, 1100
*1108*
*Vf*
*1102*
*e-*

## FIG. 11A

ANODE, 1104
REFLECTOR SHIELD,
*1106*
*1100*
BEAM, 1102
*e-*
MAGNETIC &
ELECTRIC FIELD-FREE
(NEGLECTING SPACE
CHARGE)
*1108*
*Va*  *Vf*  *Vs*

## FIG. 11B

REFLECTOR (CAN BE SCREEN), 1106

ANODE SCREEN, 1104

1108  1110

1102, BEAM →

1112  1114

→ BEAM

Vs

Vf  Va

NON-INDUCTIVE WOUND FILAMENT, 1100

## FIG. 12

1300

$I_f$ ↑  ↓ $I_f$

## FIG. 13A

1302

$I_f$ ↑  ↓ $I_f$

## FIG. 13B

FILAMENT, 1402

$f_1$

$f_2$

BEAM, 1400

## FIG. 14

ELLIPTICAL ANODE
REFLECTOR ELECTRODE,
1502

SHIELD REFLECTOR
ELECTRODE, 1500

1506

BEAM AXIS
ALONG
ELLIPSE FOCUS,
1504

HAIRPIN FILAMENT AND CYLINDRICAL
ANODE SURROUNDING HAIRPIN
FILAMENT AT SECOND FOCUS OF
ELLIPSE, 1508

$+$
$V_a$

$V_s$        $V_f$

## FIG. 15

BEAM AXIS, 1504

HAIRPIN FILAMENT, 1506

CYLINDRICAL ANODE, 1508

OPENING IN ELECTRODES FOR BEAM, 1510

## FIG. 16A

ANODE REFLECTOR ELECTRODE, 1502

SHIELD ELECTRODE, 1500

HAIRPIN FILAMENT, 1506

CYLINDRICAL ANODE, 1508

## FIG. 16B

CENTER OF ANODE SCREEN CORRESPONDS WITH ELLIPSE FOCUS

RADIAL ELECTRON TRAJECTORIES

ANODE SCREEN, 1508

OFF-CENTER HAIRPIN FILAMENT, 1506

## FIG. 17

ELLIPTICAL
REFLECTOR, 1808

1800

1804

1802

1810

f₁

f₂

CLUSTER
BEAM, 1812

1806

FILAMENTS
A, B, C

$V_s$

+

$V_f$

+

$V_a$

**FIG. 18**

FILAMENT, 1902

e-

ANODE,
1904

**FIG.
19A**

1900

FILAMENT, 1902

ELECTRON BEAM SLIT,
1906

ANODE,
1904

$V_a$

$V_f$

**FIG. 19B**

LINEAR ELECTRON GUN
ATTACHED TO ELLIPTICAL IONIZER
BODY ALONG THE MAJOR AXIS

1900

2002

e-  e-  e-  e-

2004

2000

**FIG. 20**

EP 1 255 277 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5814194 A